# EUROPÄISCHE PATENTANMELDUNG

(11) **EP 4 421 885 A1**
(43) Veröffentlichungstag der Anmeldung: **28.08.2024**
(21) Anmeldenummer: 24000018.2
(22) Anmeldetag: 03.02.2024
(51) Int. Cl.: H01L 31/042, H01L 31/044

(54) **SCHUTZ VON WELTRAUMSOLARZELLEN BEI EINER ANORDNUNG IN FORM EINES STRANGS**

(30) Priorität: 21.02.2023 DE 102023000609
(71) Anmelder: AZUR SPACE Solar Power GmbH, 74072 Heilbronn (DE)
(72) Erfinder: Zrinscak, Ivica, 74074 Hellbronn (DE)
(74) Vertreter: Koch Müller Patentanwaltsgesellschaft mbH

(57) **Zusammenfassung**

Schutz von Weltraumsolarzellen bei einer Anordnung in Form eines Strangs sich in einer X-Richtung erstreckenden Strangs und jeweils zwei in der X-Richtung unmittelbar benachbarte Weltraumsolarzellen mittels eines metallischen Verbinders einer ersten Art elektrisch seriell miteinander verschaltet sind und der Strang ein erstes Ende und ein dem ersten Ende gegenüberliegendes zweites Ende aufweist, und unmittelbar an einem der beiden Enden eine entlang einer y-Richtung ausgebildete Schutzanordnung ausgebildet ist, wobei die Schutzanordnung eine in der Y-Richtung ausgebildete erste Strangschutzdiode und ein Metallstreifen und eine zweite Strangschutzdiode umfasst, und die Schutzanordnung mittels zwei voneinander beabstandeten Metallstreifen mit einem der beiden Enden des Strangs elektrisch verschaltet ist und jede Strangschutzdiode ungehäust ist und genau einen Metallkontakt an der Oberseite und genau einen Metallkontakt an der Unterseite aufweist, und die erste Strangschutzdiode und die zweite Strangschutzdiode jeweils mittels eines elektrischen Verbinders einer zweiten Art mit dem Metallstreifen verschaltet sind.

## Beschreibung

Solarzellen für Weltraumanwendungen sind wegen den Anforderungen an einen hohen Wirkungsgrad als sogenannte III-V Mehrfachsolarzellen, d.h. mit mehrfach in Serie geschalteten p/n Übergängen, ausgebildet. Hierfür sind derzeit mindestens drei aufeinandergestapelten p/n Übergänge monolithisch integriert. Im Allgemeinen wird bei den III-V Mehrfachsolarzellen der unterste p/n Übergang durch eine Germanium Substratzelle gebildet.

Im Unterschied zu den Solarzellen für terrestrische Anwendungen, die nahezu ausschließlich als Einfachsolarzellen aus Silizium und in rechteckigen großen starren aufgebauten Modulen ausgebildet sind, werden an die Ausführungen von Weltraumsolarzellen völlig andere Anforderungen gestellt. Wichtige Bedingungen für Weltraumsolarzellen sind unter anderem, ein möglichst geringes Gewicht, einen Wirkungsgrad oberhalb 30%, eine sehr hohe Zuverlässigkeit und Robustheit über den großen Temperaturbereich, Widerstandsfähigkeit gegen Erschütterungen und auch gegen hohe Dosen von Protonen- und Elektronenstrahlung. Indem im Vakuum des Weltraums eine Abgabe von Wärme d.h. eine Kühlung von elektrischen Bauteilen ausschließlich in Form von Strahlung möglich ist, ist die Wärmeabfuhr von elektrischen Bauteilen wesentlich aufwändiger als bei terrestrischen Anwendungen.

Infolgedessen entwickelten sich die Herstellung und die Aufbautechnik für Module für Weltraumsolarzellen, d.h. die Art von Paneelen, völlig getrennt und unterschiedlich zu der Herstellung und der Aufbautechnik von terrestrischen Solarzellenmodulen.

So werden Weltraumsolarzellen, nachdem diese auf eine Dicke unterhalb von 150 µm gedünnt sind, nacheinander in einzelnen Reihen, auch als Stränge bezeichnet, angeordnet. Die Weltraumsolarzellen mittels speziellen ebenfalls sehr leichten und flexiblen Metallverbindem entlang des Strangs untereinander verschweißt und hierdurch elektrisch in Serie verschaltet. Die Reihen sind entlang der Längsrichtung flexibel und werden auf ultraleichten kohlefaserverstärkten starren Paneelen oder auf dünnen flexiblen Trägerfolien angeordnet.

Ein Paneel umfasst im Allgemeinen mehrere Stränge. Auf einer Paneele sind mehrere Stränge untereinander mittels flexiblen Kabeln auf der Rückseite des jeweiligen Paneels in Serie und / oder parallel verschaltet. Hierzu weist das Paneel auf der Rückseite ein Kabelbaum auf. Des Weiteren sind auf der Rückseite des Paneels weitere elektrische Bauteile angeordnet.

Im Unterschied zu den vorgenannten Ausführungen für Weltraumsolarzellen sind terrestrische Solarzellen starr auf einer mechanisch starren, schweren und stabilen Trägerplatte angeordnet und insgesamt mit einer starren, insbesondere hagelfesten Glasplatte bedeckt. Hierbei ist die Glasplatte für jeweils genau einem Paneel auf einem umlaufenden Rahmen angeordnet, wobei jedes Paneel mittels des Rahmens und mittels Klebstoffs, Insbesondere Silikon, gegenüber Umgebungseinflüssen dicht ausgebildet ist.

Das Gesamtgewicht eines Paneels für terrestrische Solarzellen ist um viele Größenordnungen höher als ein ultraleichtes Paneel von Weltraumsolarzellen. Des Weiteren lassen sich bei terrestrischen Anwendungen defekte Paneele leicht austauschen. Auch weist ein Paneel von terrestrischen Solarzellen daher nur wenige Schutzdioden auf.

Im Unterschied dazu, weisen bei den Paneelen für den Weltraum jede einzelne der Weltraumsolarzellen eine eigene Bypassdiode auf, damit bei einem Ausfall einer Weltraumsolarzelle nicht alle Weltraumsolarzellen des jeweiligen Strangs ausfallen, d.h. dass nicht der gesamte Strang ausfällt.

Meist sind bei der Weltraumsolarzelle die zugeordnete Bypassdiode in einer der beiden abgeschnittenen Ecken, den sogenannten "cropped corner", angeordnet. Jede Bypassdiode ist mittels eines metallischen Verbinders unmittelbar mit der jeweiligen Welttraumsolarzelle verbunden. Aus Gründen der Zuverlässigkeit sind die Verbinder immer verschweißt.

Zum Schutz der Weltraumsolarzellen vor Weltraumstrahlung sind die Vorderseiten jeder der Weltraumsolarzellen und die in der Ecke angeordnete Bypassdiode mittels eines separaten sehr dünnen Deckglases vor kurzwelligem UV-Licht geschützt.

Die ultradünnen Deckgläser weisen jeweils eine Dicke kleiner als 0,2 mm auf und sind mittels eines Klebers mit der Vorderseite der Weltraumsolarzelle verbunden. Die in den "cropped corner" angeordneten Bypassdioden sind hierbei von dem Deckglas der zugeordneten Weltraumsolarzellen mit überdeckt. Anders ausgedrückt, die Bypassdioden weisen kein eigenes d.h. separates Deckglas auf.

Ein Nachteil der vorgenannten Anordnung ist es, dass sich bei einem Fehler bei dem Paar, bestehend aus einer Weltraumsolarzelle und der zugeordneten Bypassdiode, einzelne Teile eines Paares nur mit einem sehr großen Aufwand austauschen lassen.

Sind die Weltraumsolarzellen bereits auf dem Strang angeordnet, ist ein Austausch eines defekten Teils auf dem Strang noch aufwendiger, so dass der gesamte Strang defekt ist und insgesamt durch einen anderen Strang ersetzt wird. Anders ausgedrückt, eine Reparatur oder Nacharbeit ist wirtschaftlich nicht sinnvoll.

Eine Anordnung von Weltraumsolarzellen ist aus der DE 10 2004 044 061 A1 bekannt. Die Weltraumsolarzellen sind in Form eines Strangs, im englischen auch als String bezeichnet, ausgebildet. Wie oben ausgeführt, weist jede der Weltraumsolarzellen eine in der Ecke der Weltraumsolarzelle angeordnete Bypassdiode auf, wobei die Bypassdiode elektrisch jeweils antiparallel mit der jeweiligen Weltraumsolarzelle verschaltet und mittels des gemeinsamen Deckglases geschützt ist.

Zusätzlich zu den jeweiligen Bypassdioden enthält jeder Strang von Weltraumsolarzellen eine oder mehrere gehäuste oder gekapselte d.h. mit Moldmasse umgebene Strangschutzdioden. Die Aufgabe der Strangschutzdiode ist es, Ströme in einer in Vergleich zu dem Normalbetrieb umgekehrten Richtung d.h. in einer Rückwärtsrichtung zu unterdrücken, um hierdurch Stromverluste zu reduzieren.

Die Strangschutzdioden sind in einer Durchlassrichtung, d.h. in einer Vorwärtsrichtung in Serie mit den Weltraumsolarzellen eines Strangs verschaltet. Anders ausgedrückt, bei einer Bestrahlung durch die Sonne wird von den auf dem Strang angeordneten Weltraumsolarzellen Strom von wenigen Ampere, typischerweise 1,5 A, erzeugt, wobei dann der gesamte Strom durch die in der Vorwärtsrichtung gepolte Strangschutzdiode hindurchfließt.

In einer Rückwärtsrichtung treten Spannungen im Allgemeinen zwischen 10V und 100V insbesondere dann auf, wenn beispielsweise einer der mehreren mit einander verschalteten Stränge nicht oder nur wenig Sonneneinstrahlung und einer der anderen Stränge der vollen Sonneneinstrahlung ausgesetzt ist. Ein Stromfluss durch die im Dunklen liegenden Stränge wird von der nun in der Rückwärtsrichtung gepolten Strangschutzdiode unterdrückt.

Aus Gründen der Zuverlässigkeit und Flexibilität wird für in der Anwendung befindlichen Ausführungen für jeden Strang eine oder mehrere gehäuste Strangschutzdiode auf der Rückseite des Panels angeordnet und mittels flexiblen elektrischen Leitungen mit dem Strang auf der Vorderseite des Paneels verschaltet. Aufgrund der Anordnung sind die gehäusten Strangschutzdioden auf der Rückseite des Paneels vor einem zusätzlichen Wärmeeintrag von der Sonne geschützt, so dass die Wärmeabfuhr bei höherer Strombelastung nicht problematisch wird.

Es sei angemerkt, dass aufgrund der fehlenden Konvektion im Weltraum eine passive Kühlung nur in Form von Strahlungswärme erfolgt, wobei bei den für die Strangschutzdioden, die üblicherweise als Si-Dioden ausgebildet sind, maximal zulässigen Temperaturen von kleiner gleich 170°C nur wenig Energie abstrahlen lässt.

Aus Redundanzgründen und / oder um die Wärmeentwicklung zu reduzieren sind oft mehrere Strangschutzdioden parallel verschaltet.

Aus der US 2018 / 0062011 A1 insbesondere der Fig. 3a und Fig. 3b und Fig. 4a und Fig. 4b ist eine integrierte Anordnung von auf der Vorderseite angeordneten Strangschutzdioden bekannt. Je Strang sind eine oder mehrere Strangschutzdioden am Ende eines jeden Strangs, vergleichbar der integrierten Anordnung der Bypassdiode, in einer zweiten Ecke der am Ende des Strangs angeordneten Weltraumsolarzelle integriert. Die zweite Ecke und die erste Ecke sind bei der Weltraumsolarzelle an der gleichen Seite angeordnet.

Hierbei ist eine Rückseite oder eine Vorderseite der Strangschutziode mittels eines weiteren metallischen Verbinders mit der Rückseite oder der Vorderseite der unmittelbar benachbarten Weltraumsolarzelle elektrisch in Serie verschaltet. An der Oberseite der Strangschutzdiode ist ein zweiter Kontakt ausgebildet. Der zweite Kontakt wird über einen weiteren Verbinder mit einem rechteckigen durchgehenden metallischen Kontaktteil am Ende des Weltraumsolarzellenstrangs verschaltet. Entsprechend der Bypassdiode ist auch die Strangschutzdiode mit dem Deckglas der unmittelbar benachbarten Weltraumsolarzelle verklebt.

Die Strangschutzdiode sind, wie oben bereits angeführt, mit der jeweiligen Weltraumsolarzelle, entsprechend der Bypassdiode integriert, d.h. die Strangschutzdiode ist gemeinsam mit der Weltraumsolarzelle auf einer Kunststoffträgerfolie bzw. auf dem Paneel angeordnet.

Hierdurch wird die Herstellung von Strängen wesentlich aufwändiger, da insbesondere die Strangschutzdioden im Vergleich zu den Bypassdioden wesentlich größer und leistungsfähiger ausgeführt sein müssen, um die Strombelastung des gesamten Strangs in Vorwärtsrichtung mit möglichst geringen elektrischen Verlusten zu verkraften.

Anders ausgedrückt, der Platz in den Ecken der Weltraumsolarzellen ist sehr beschränkt. Auch hat sich gezeigt, dass eine dreieckige Ausführung wegen des zusätzlichen Aufwands beim Sägen der Strangschutzdioden aus dem Si-Herstellungssubstrat nicht praktikabel ist.

Des Weiteren ist die Bestrahlung der Sonne im Weltraum wesentlich intensiver als auf der Erde. Eine Kühlung der Strangschutzdioden bei der intensiven Sonneneinstrahlung und gerade in der Betriebsart, bei der die hohen Ströme durch die Strangschutzdioden fließen, ist oft nicht hinreichend. Sofern die Temperatur bei den Si-Strangschutzdioden in die Nähe von 150°C steigt, erhöht sich die elektrische Verlustleistung bei den Strangschutzdioden zusätzlich, was zu einem Ausfall führen kann.

Des Weiteren weiß der Fachmann, dass sich auch der Ausschuss bei der Strangherstellung erhöht. Gerade wegen der hohen Integrationsstufe ist eine Reparatur d.h. Nacharbeit bei Fehlern in der Verbindung der Strangschutzdlode mit der Weltraumsolarzelle oder bei Fehlern an den Schutzdioden sowohl wirtschaftlich als auch wegen den hohen Anforderungen an die Zuverlässigkeit nicht durchführbar.

Aufgrund der angeführten Nachteile für eine integrierte Anordnung auf der Vorderseite des Paneels, wird bei der Herstellung von Weltraumsolarpanelen die oben beschriebene diskrete Anordnung der Strangschutzdioden auf der Rückseite der Panels unter Verwendung von flexiblen Kabeln benutzt.

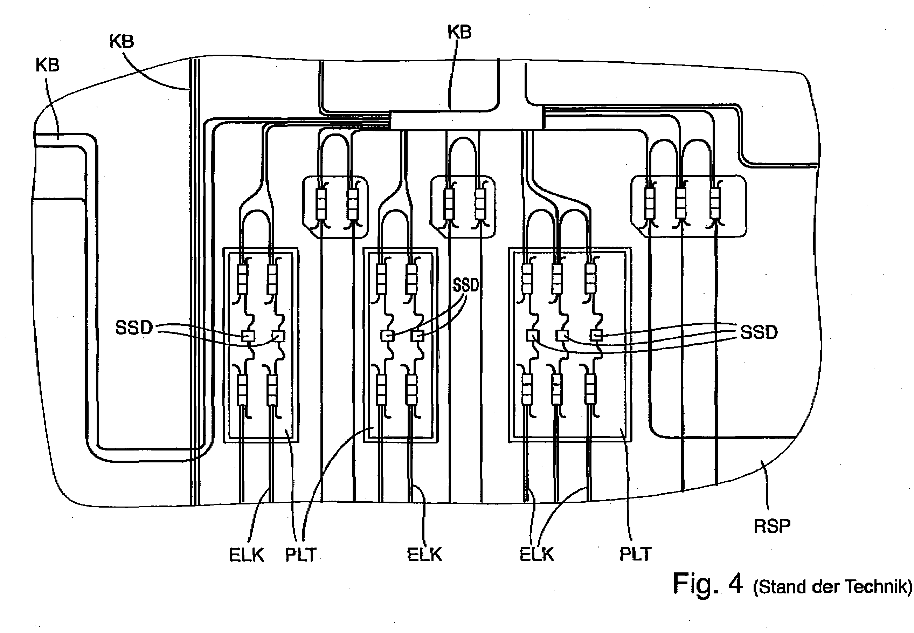

Eine derartige Ausführungsform ist in der Fig.4 dargestellt. Hierbei wird ein Ausschnitt der Rückseite eines Paneels für Weltraumanwendungen gezeigt.

Die einzelnen auf der Vorderseite des Paneels ausgebildeten Stränge sind jeweils mittels einer Vielzahl von flexiblen Kabeln ELK auf der Rückseite auf Platinen PLT verschaltet. Die Vielzahl von Kabeln ELK sind in Form von Kabelbäumen KB zusammengefasst: Auf den größeren Platinen PLT sind einzelne gehäuste Strangschutzdioden SSD angeordnet.

Es versteht sich, dass ein der in der Fig. 4 dargestellte übliche Aufbau einen gewissen Aufwand erfordert und einiges an zusätzlichem Gewicht verursacht.

Vor diesem Hintergrund besteht die Aufgabe der Erfindung darin, eine Vorrichtung anzugeben, die den Stand der Technik weiterbildet.

Die Aufgabe wird durch eine Stranganordnung von Weltraumsolarzellen mit den Merkmalen des Patentanspruchs 1 gelöst. Vorteilhafte Ausgestaltungen der Erfindung sind Gegenstand von Unteransprüchen.

In dem Gegenstand der vorliegenden Erfindung wird eine Anordnung zum Schutz von Weltraumsolarzellen bereitgestellt, wobei wenigstens ein Teil der Weltraumsolarzellen reihenförmig in Form eines Strangs entlang einer X-Richtung angeordnet sind.

Es versteht sich hierbei, dass längere in der X-Richtung ausgebildete Stränge, insbesondere wegen den geometrischen Anforderungen Paneelen, auch in mehreren insbesondere nebeneinander angeordneten Reihen anordnen und in Serie verschalten lassen.

Der Strang umfasst wenigstens zwei nacheinander angeordnete Weltraumsolarzellen, wobei die entlang der X-Richtung unmittelbar benachbarten Weltraumsolarzellen mittels einem oder mehreren metallischen Verbindern elektrisch seriell miteinander verschaltet sind.

Die Weltraumsolarzellen weisen jeweils eine in einer X-Richtung und in einer Y-Richtung ausgebildete Empfangsfläche auf.

Ferner weist der Strang eine Vorderseite und eine Rückseite auf, wobei die Empfangsflächen der Weltraumsolarzellen auf der Vorderseite des Strangs ausgebildet sind.

Ferner weist der Strang ein erstes Ende und ein dem ersten Ende gegenüberliegendes zweites Ende auf, wobei die beiden Enden sich jeweils in der y-Richtung entlang einer Seite der an den Enden des Strangs angeordneten Weltraumsolarzelle erstrecken.

Jede Weltraumsolarzelle weist eine mit der jeweiligen Weltraumsolarzelle verschaltete Bypassdiode auf, wobei die Weltraumsolarzellen jeweils eine in einer Z-Richtung ausgebildete Dicke zwischen 30 µm und 300 µm oder ein Dicke zwischen 50 µm und 160 µm aufweisen.

Des Weiteren ist auf der Vorderseite eine Schutzanordnung an wenigstens einem der beiden Enden entlang der y-Richtung ausgebildet, wobei die Schutzanordnung mit der an dem Ende angeordneten Weltraumsolarzelle des Strangs mittels eines der metallischen Verbinder elektrisch verschaltet ist.

Die Schutzanordnung umfasst eine erste Strangschutzdiode und ein Metallstreifen und eine zweite Strangschutzdiode. Der Metallstreifen weist ein erstes kopfseitiges Ende und ein Zwischenstück und ein zweites kopfseitiges Ende auf.

In einer ersten Alternative ist die erste Strangschutzdiode in der y-Richtung mittels eines der metallischen Verbinder mit dem ersten kopfseitigen Ende des Metallstreifens in Serie verschaltet.

Ferner ist die zweite Strangschutzdiode in der y-Richtung mittels eines der metallischen Verbinder mit dem zweiten kopfseitigen Ende des Metallstreifens in Serie verschaltet.

Die Verbinder weisen jeweils zwei voneinander durch ein Verbindungsstück beabstandete Kontaktflächen auf.

Alternativ sind in einer zweiten Alternative die erste Strangschutzdiode unmittelbar an dem ersten kopfseitigen Ende auf dem Metallstreifen und die zweite Strangschutzdiode unmittelbar an dem zweiten kopfseitigen Ende auf dem Metallstreifen angeordnet.

In beiden Alternativen sind in einer ersten Ausführungsform die beiden Strangdioden in der X-Richtung jeweils mittels einen der metallischen Verbinder elektrisch in Serie mit der am Ende des Strangs angeordneten Weltraumsolarzelle verschaltet.

In einer nicht beanspruchten Ausführungsform sind in beiden Alternativen in einer zweiten Ausführungsform die Strangschutzdioden jeweils mittels einem der metallischen Verbinder mit einem flexiblen Anschlussleitung verschaltet, wobei der Metallstreifen in der X-Richtung mittels der Verbinder einfach oder mehrfach mit der an dem einen Ende des Strangs angeordneten Weltraumsolarzelle verschaltet ist.

Es versteht sich, dass jede Strangschutzdiode ungehäust ist und genau einen p/n Übergang und einen Metallkontakt an einer Oberseite und einen Metallkontakt an einer Unterseite aufweist.

Hierbei überdecken die Metallkontakte jeweils wenigstens 50% der Gesamtfläche der Oberseite und der Unterseite auf.

Ferner weist jede Strangschutzdiode auf der Oberseite eine eigene d.h. separate Abdeckung auf, wobei die Abdeckung mit der Oberseite der Strangschutzdiode verklebt ist.

Ferner ist die Schutzanordnung insgesamt flach ausgebildet und weist eine in einer Z-Richtung ausgebildete Dicke von kleiner als 1 mm auf.

In der Y-Richtung weist die Ausdehnung der gesamten Schutzanordnung wenigstens einen Faktor fünf größere Ausdehnung als in der X--Richtung auf.

Überraschenderweise zeigte sich, dass eine Integration der Strangschutzdioden mittels der vorliegenden Anordnung auf der Vorderseite des Strangs von erheblichem Vorteil ist.

Insbesondere ist ein Vorteil der Schutzanordnung, dass sich der Verschaltungsaufwand auf der Rückseite des Strangs bzw. des Paneels erheblich reduziert.

Auch lässt sich durch die vorteilhafte Anordnung der beiden Strangschutzanordnung in Zusammenhang mit dem Metallstreifen bei einem Fehler bei der Herstellung die einzelne Strangschutzdiode ersetzen, ohne den Strang mechanisch zu beeinflussen.

Auch zeigte sich, dass durch die vorteilhafte Integration der Strangschutzdioden in Zusammenhang mit dem Metallstreifen sich die Herstellungskosten reduzieren lassen und sich die Zuverlässigkeit erhöht.

Indem die Strangschutzdioden unmittelbar mit dem Metallstreifen verbunden oder direkt mittels eines großflächigen Verbinders mit dem Metallstreifen verschaltet sind, werden die Strangschutzdioden auch bei maximaler Leistung und direkte Bestrahlung durch die Sonne nicht zu heiß..

Neben der guten thermischen Ankopplung ist hierfür auch der hohe Reflektionsgrad von der Metallfläche auf der Oberseite der Strangschutzdiode wichtig. Vorzugsweise liegt der Gesamtreflektionsgrad der Anordnung in dem sichtbaren und infraroten Bereich oberhalb 80% oder oberhalb 90%. Vorteilhaft ist es, wenn die Abdeckschicht für infrarote Strahlung durchlässig d.h. transparent ist, um die die Strangschutzdioden mittels der Abstrahlung im infraroten Bereich Wärme abzuführen.

In einer Ausführungsform weist die Oberseite der Strangschutzdiode eine durchgängige oder eine mehr als 80% der Oberfläche überdeckende metallische Schicht auf, um die Sonnenstrahlung zu reflektieren bzw. die Wärme des Bauelements gut abzustrahlen.

In einer Ausführungsform liegt der in der X-Richtung ausgebildete Abstand zwischen der am Ende des Strangs angeordneten Weltraumsolarzelle und der Schutzanordnung in einem Bereich zwischen 0,01 mm bis 2,0 mm oder in einem Bereich zwischen 0,1 mm und 1 mm oder in einem Bereich zwischen 0,2 mm und 0,5 mm.

Des Weiteren liegt die Empfangsfläche der Weltraumsolarzelle jeweils zwischen 4 cm² und 500 cm² oder zwischen 30 cm² und 350 cm² oder zwischen 70 cm² und 160 cm².

Es sei angemerkt, dass mit dem Begriff des "metallischen Verbinders" ein Verbinder umfassend oder bestehend aus einem Metall verstanden wird. Insbesondere umfasst ein metallischer Verbinder auch einen mehrschichten Aufbau beispielsweise aus einer und einer oder mehreren organischen Trägerschichten oder mehreren Metallschichten und wenigstens einer organischen Trägerschicht oder mehreren unterschiedlichen Metallschichten und einer oder mehrere organischen Trägerschichten.

Es versteht sich, dass mit dem Begriff "verschaltet" eine elektrische Verbindung verstanden wird.

In einer Weiterbildung ist die elektrische Verbindung zwischen der Strangschutzdiode und der ersten Kontaktfläche des Verbinders und / oder die elektrische Verbindung zwischen der zweiten Kontaktfläche und dem Metallstreifen oder der Weltraumsolarzelle jeweils stoffschlüssig ausgebildet.

In einer anderen Weiterbildung liegt der Kontaktwiderstand in der elektrischen Verbindung unterhalb 10 Ohm oder unterhalb 5 Ohm oder unterhalb 1 Ohm.

Indem ein Strang eine größere Anzahl von Weltraumsolarzellen enthält, müssen die elektrischen Leistungsdaten der Strangschutzdiode an die elektrischen Daten des Weltraumsolarzellenstrangs angepasst sein. Anders ausgedrückt, die Stromtragfähigkeit der Strangschutzdioden liegt wenigstens um 50% oberhalb des maximalen Stroms des Strangs bei voller Sonneneinstrahlung und umfasst im Allgemeinen wenige Ampere.

Vorzugsweise liegt die Stromtragfähigkeit der Strangschutzdiode in einem Bereich zwischen 100 mA und 10 A oder zwischen 1 A und 5 A.

Vorzugsweise sind die Strangschutzdioden aus Silizium oder aus GaAs mit ausgebildet.

Ein Vorteil von GaAs gegenüber Si-Silizium ist, dass der Spannungsabfall in der Vorwärtsrichtung geringer ist.

In einer Weiterbildung wird als Verbinder und oder als Metallstreifen "Kovar" -Material verwendet.

In einer Ausführungsform umfasst der Verbinder und / oder der Metallstreifen vorzugsweise mehr als 50% Eisen und vorzugsweise mehr als 20% Kobalt und vorzugsweise mehr als 10% Nickel.

In einer anderen Ausführungsform wird als Verbinder ein "Invar" Verbinder verwendet.

In einer Weiterbildung umfasst oder besteht der Verbinder und / oder der Metallstreifen aus reinem Silber und / oder umfasst Molybdän, wobei das Molybdän vorzugsweise einseitig oder beidseitig mit Silber beschichtet ist.

Um eine zuverlässige elektrische und mechanische Verbindung auszubilden, weisen die Verbinder vorzugsweise Metallfahnen auf. Insbesondere sind die Metallfahnen für Schweißprozesse ausgelegt.

In einer Weiterbildung werden die Verbinder der Schutzanordnung genau mit einem Ende des Strangs mehrfach d.h. zwischen zwei und sechsmal verschweißt. Es versteht sich, dass die Schweißstellen in der Y-Richtung jeweils zueinander beabstandet sind.

In einer anderen Weiterbildung sind die Kontaktflächen oder die Kontaktfahnen der Verbinder an dem einen Ende des Strangs an genau zwei zueinander in der y-Richtung beabstandeten Kontaktstellen mit der am Ende angeordneten Weltraumsolarzelle und / oder der Bypassdiode verschweißt. Hierbei beträgt der Abstand zwischen den beiden Kontaktstellen in der y-Richtung ein Mehrfaches von dem Abstand der jeweiligen Kontaktstelle zudem entlang der x-Richtung ausgebildeten Rand der Weltraumsolarzelle.

Anders ausgedrückt, die beiden Schweißstellen für die Verbindung mit den Strangschutzdioden sind in der Nähe der jeweiligen in x-Richtung ausgebildeten äußeren Rand des Strangs angeordnet.

In einer Ausführungsform umfasst jede der Strangschutzdiode wenigstens zwei elektrisch zu einander parallel verschaltete Strangschutzdioden. Hierbei sind die beiden parallel verschalteten Strangschutzdioden vorzugsweise in der x-Richtung parallel in der Y-Richtung zueinander beabstandet, angeordnet. Ein Vorteil ist, dass mittels der Parallelschaltung bei Ausfall einer der Strangschutzdioden eine einfache Redundanz gegeben ist.

In einer Weiterbildung sind je Strang genau vier Strangschutzdioden angeordnet, d.h. mit dem Strang verschaltet. Hierbei sind jeweils zwei der Strangschutzdioden in Serie geschaltet und bilden zwei zueinander parallele Zweige aus, wobei die beiden Knoten der Zweige unmittelbar miteinander verschaltet sind, d.h. miteinander kurzgeschlossen sind.

Ein Vorteil trotz des etwas höheren Widerstand der Serienschaltung in der Vorwärtsrichtung ist, dass durch die erhöhte d.h. mehr wie zweifache Redundanz auch bei Ausfall von mehr als einer Strangschutzdiode der jeweilige Strang immer noch von einer oder mehreren Strangschutzdioden in der Rückwärtsrichtung geschützt ist.

In einer Weiterbildung sind an beiden Enden zwei jeweils zueinander parallel geschaltete Strangschutzdioden ausgebildet. Hierbei wird eine Serienschaltung aus Strangschutzdiode, Weltraumsolarzellen des Strangs bzw. der Bypassdioden und Strangschutzdiode ausgebildet.

Ein Vorteil ist, dass durch die mehr als zweifache Redundanz die Ausfallsicherheit gegenüber der Ausführungsform mit nur zwei Strangschutzdioden weiter erhöht ist. Vorzugsweise weisen die Strangschutzdioden untereinander die gleichen elektrischen Daten oder in einer ersten Näherung die fast gleichen elektrischen Daten auf.

In einer anderen Ausführungsform sind anstelle einer einzigen Strangschutzdiode zwei miteinander seriell verschaltete Strangschutzdioden ausgebildet. In einer Weiterbildung ist die eine oder beide der in Serie verschalteten Strangschutzdioden aus einer Kombination von seriell und parallel verschalteten Strangschutzdioden ausgebildet. Ein Vorteil ist, dass sich mit der seriellen Verschaltung in Rückwärtsrichtung auf einfache Weise eine höhere Sperrspannung erzielen lässt.

In einer Ausführungsform ist die Strangschutzdiode aus Silizium oder aus GaAs ausgebildet.

In einer anderen Weiterbildung weist die Strangschutzdiode einen Sperrspannungsbereich zwischen 10 V und 1000 V, oder zwischen 30 V und 600 V oder zwischen 80 V und 300 V oder zwischen 10 V und 300 V auf.

In einer Ausführungsform weist die Strangschutzdiode einen Strombereich zwischen 0,1 A und 5A oder zwischen 0,5 A und 2 A auf.

In einer Ausführungsform sind auf dem Strang als Weltraumsolarzelle ausschließlich III-V Mehrfach-Weltraumsolarzellen angeordnet.

In einer anderen Ausführungsform sind auf einem Strang wenigstens zwei und höchstens zwanzig III-V Mehrfach-Weltraumsolarzellen elektrisch in Serie verschaltet.

In einer Weiterbildung umfasst oder besteht die serielle Verschaltung der Weltraumsolarzellen aus fünf Weltraumsolarzellen oder zehn Weltraumsolarzellen oder zwanzig Weltraumsolarzellen.

In einer anderen Weiterbildung umfasst oder besteht die serielle Verschaltung aus insgesamt höchstens vierzig oder höchstens einhundert in Serie verschalteten Weltraumsolarzellen.

In einer Weiterbildung verteilen sich die seriell verschalteten Weltraumsolarzellen auf wenigstens zwei oder drei Stränge. Höchstens verteilen sich die seriell verschalteten Weltraumsolarzellen auf zehn Stränge.

In einer nicht Ausführungsform ist ein Strang, nachfolgend auch als Gesamtstrang bezeichnet, in mehrere unmittelbar nebeneinander liegende Teilstücke aufgeteilt, wobei die Teilstücke mit einander seriell verschaltet sind und das erste Ende dem zweiten Ende in der X-Richtung dann nicht mehr gegenüberliegt. Es versteht sich, dass die beiden Teilstücke vorzugsweise parallel zueinander und in der Y-Richtung zueinander beabstandet angeordnet sind. Auch sei angeführt, dass die beiden Teilstücke des Gesamtstrangs gleich lang oder nicht gleich lang ausgebildet sind.

Hierbei sind die Empfangsflächen der Weltraumsolarzellen ausschließlich parallel zu der X-Richtung und parallel der Y-Richtung ausgebildet. Anders ausgedrückt die Empfangsflächen liegen vorzugsweise in einer X-Y Ebene.

In einer Weiterbildung weisen die Verbinder eine erste Kontaktfläche und eine zweite Kontaktfläche auf, wobei eine der beiden Kontaktflächen mit dem Metallkontakt an der Unterseite oder mit dem Metallkontakt an der Oberseite der Strangschutzdiode verschaltet ist und die andere der beiden Kontaktflächen mit dem Metallstreifen verschaltet ist.

In einer Weiterbildung sind bei den Verbindern die beiden Kontaktflächen gleich oder unterschiedlich ausgebildet. In einer anderen Weiterbildung weisen bei den Verbindern wenigstens eine der beiden Kontaktflächen oder beide Kontaktflächen jeweils eine Kontaktfahne oder mehrere Kontaktfahnen auf.

In einer Weiterbildung ist das Verbindungsstück zwischen den beiden Kontaktflächen wenigsten bei einem Teil der Verbinder mäanderförmig ausgebildet, um die beiden Kontaktflächen mechanisch voneinander zu entkoppeln.

Hierbei wird mit dem Begriff mäanderförmig verdeutlicht, dass bei den Verbindern das Verbindungsstück quer zu einer Geraden, die die beiden Kontaktflächen verbindet, eine größere Erstreckung als in Richtung der Geraden aufweist und quer zu der Richtung der Geraden optional mehrere Ausbuchtungen und Aussparungen aufweist.

Anders ausgedrückt, das Verbindungsstück ähnelt bei manchen Ausführungsformen der Verbinder der Form eines Mäanders.

In einer Weiterbildung sind die beiden Kontaktflächen der Verbinder jeweils flach ausgebildet und weisen eine in der Z-Richtung ausgebildete Dicke zwischen 0,01 mm und 0,7 mm auf. Vorzugsweise ist die Dicke der Kontaktflächen über die Erstreckung konstant.

In einer Weiterbildung weisen die Verbinder eine rechteckförmige Fläche auf, wobei die lange Seite der rechteckförmigen Fläche eine mindestens Faktor 5 größere Ausdehnung als die kurze Seite aufweist.

In einer anderen Weiterbildung weisen alle Weltraumsolarzellen des Strangs jeweils eine Bypassdiode auf, wobei die Bypassdiode unmittelbar mit der jeweiligen Weltraumsolarzelle verschaltet ist.

In einer Weiterbildung ist eine der beiden Strangschutzdioden mit der Bypassdiode von der an einem der beiden Enden angeordneten Weltraumsolarzelle unmittelbar verschaltet.

In einer Ausführungsform ist an beiden Enden des Strangs eine Schutzanordnung ausgebildet. Ein Vorteil ist hierfür, dass sich hierdurch die Redundanz bei einem Ausfall eines Teils oder der gesamten an einem der beiden Enden ausgebildeten Schutzanordnung erhöht.

In einer Weiterbildung fließt bei einem Lichteinfall auf die Vorderseite der Weltraumsolarzellen ein mittels des Lichteinfalls in den Weltraumsolarzellen erzeugten Stroms ausschließlich durch die Strangschutzdioden und den Metallstreifen zu der Anschlussleitung.

In einer Weiterbildung weisen die Kontaktfahnen eine Dicke zwischen 0,01 mm und 0,5 mm oder zwischen 0,02 mm und 0,2 mm auf.

In einer Ausführungsform weist die Abdeckung der Strangschutzdiode eine hohe Transmission im infraroten Bereich auf bzw. ist im Infraroten transparent, um die Wärmestrahlung zu reflektieren bzw. die Abstrahlung von Wärme von der Strangschutzdiode nicht zu unterdrücken.

In einer anderen Ausführungsform ist die Schutzanordnung unmittelbar an einem der beiden Enden ausgebildet, wobei der Abstand in der X-Richtung zwischen der Schutzanordnung und der mit der Schutzanordnung verschalteten Weltraumsolarzelle in einem Bereich zwischen 10 µm und 10 mm oder in einem Bereich zwischen 100 µm und 2 mm liegt. Der Abstand zwischen der Weltraumsolarzelle und der Schutzanordnung ist in einer ersten Näherung jeweils durch die Länge des Verbindungsstückes bei den Verbindern bestimmt.

In einer Weiterbildung ist mittels den Metallstreifen und / oder der Anschlussleitung eine Kühlung für die Strangschutzdioden ausgebildet.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die lateralen und die vertikalen Erstreckungen sind nicht maßstäblich und weisen, sofern nicht anders angegeben, auch kei= ne ableitbaren geometrischen Relationen zueinander auf. Darin zeigen, die
- Figur 1a, 1b: verschiedene Ausführungen eines Strangs von Weltraumsolarzellen mit einer an beiden Enden ausgebildeten Schutzanordnung verbunden jeweils mit einer der an dem jeweiligen Ende angeordneten Weltraumsolarzelle,
- Figur 2a - 2e: detaillierte Ansichten unter anderem von der Vorderseite, der Seite und Rückseite der mit einer Weltraumsolarzelle WSZ verschalteten Schutzanordnung SA dargestellt,
- Figur 3a - 3f: verschiedene detaillierte Ansichten auf die Schutzanordnung und auf die Verbinder mit Strangschutzdioden,
- Figur 4: eine Draufsicht auf eine diskrete Ausführungsform von Strangschutzdioden auf der Rückseite eines Panels nach dem Stand der Technik.

Vorliegend werden Weltraumsolarzellen WSZ mit einer sogenannten n auf p Ausführung verwendet. Die Weltraumsolarzellen WSZ weisen eine in Richtung der Sonneneinstrahlung ausgerichtete Oberseite und eine gegenüberliegende Unterseite auf. Der n-Emitter ist an der Oberseite der Weltraumsolarzelle ausgebildet.

Des Weiteren ist sind die Weltraumsolarzellen WSZ jeweils als III-V Mehrfachzellen ausgebildet. Im Allgemeinen umfassen die Weltraumsolarzellen eine in einem Germanium Substrat ausgebildete Germaniumzelle.

Die flächige entlang einer Linie angeordneten Weltraumsolarzellen WSZ weisen ein erstes kopfseitiges Ende, an dem bei einer Sonneneinstrahlung ein positives Potential + anliegt und ein zweites kopfseitigen Ende, an dem ein negatives Potential - anliegt, auf.

Es sei angemerkt, dass an dem ersten kopfseitigen Ende auch das negative Potential - und an dem zweiten kopfseitigen Ende das positive Potential + ausgebildet ist.

Es versteht sich, dass die Weltraumsolarzellen WSZ in einer alternativen Ausführung eine p auf n Ausführung aufweisen.

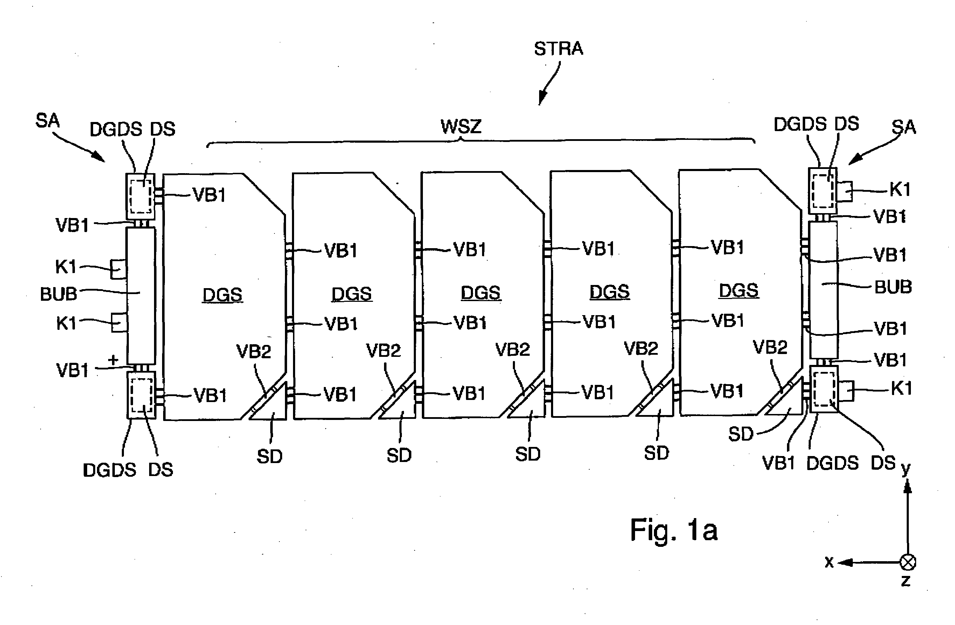

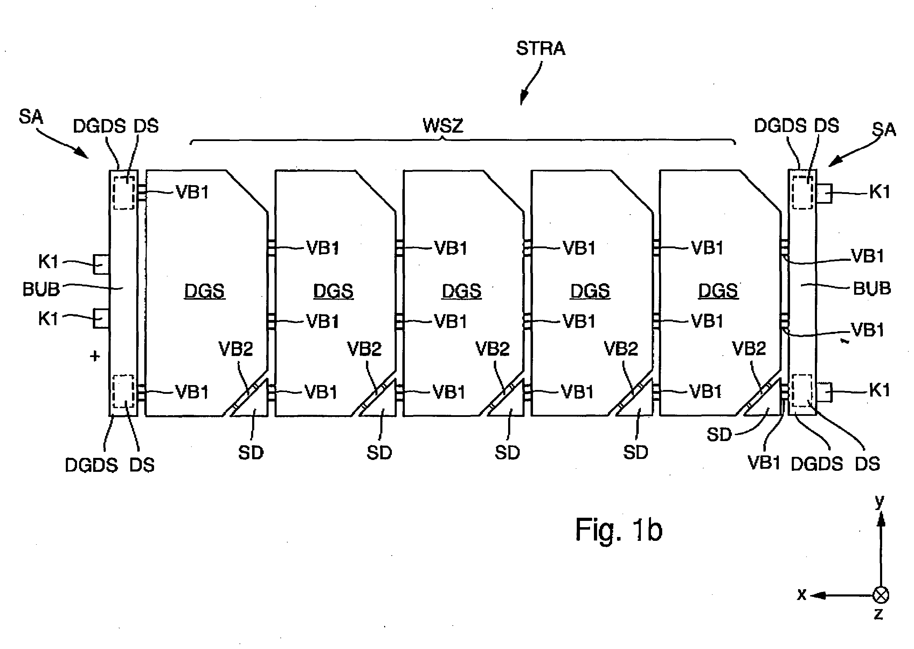

Die Abbildungen der Figur 1a und der Figur 1b zeigen verschiedene Ausführungen der Anordnung von Weltraumsolarzellen WSZ in Form eines Strangs STRA mit einer an beiden Enden ausgebildeten Schutzanordnung SA, wobei die jeweilige Schutzanordnung SA mit einer der an dem jeweiligen Ende angeordneten Weltraumsolarzelle WSZ verschaltet ist.

Die Schutzanordnung SA ist insgesamt flach ausgebildet und weist eine in einer Z-Richtung ausgebildete Dicke kleiner als 1 mm auf.

Die Ausdehnung der gesamten Schutzanordnung SA weist in der Y-Richtung wenigstens einen Faktor fünf größere Ausdehnung als in der X--Richtung auf.

Eines der beiden Enden der Schutzanordnung WSZ ist als positiver Spannungspol + und das andere Ende als negativer Spannungspol - ausgebildet.

Es versteht sich jedoch, dass in einer nicht dargestellten Ausführungsform nur eine Schutzanordnung SA entweder an dem an Ende mit dem positiven Spannungspol + oder an dem Ende mit dem negativen Spannungspol - ausgebildet ist.

Vorliegend sind die Weltraumsolarzellen WSZ nacheinander in Form des sich in einer X-Richtung erstreckenden Strangs STRA angeordnet, wobei der Strang STRA insgesamt fünf Weltraumsolarzellen WSZ umfasst. Jede der fünf Weltraumsolarzellen WSZ ist mit einem eigenen Deckglas DGS auf einer Oberseite geschützt.

Jeweils zwei in der X-Richtung unmittelbar benachbarte Weltraumsolarzellen WSZ sind mittels mit genau zwei metallischen Verbindern VB1 elektrisch seriell miteinander verschaltet.

Die Weltraumsolarzellen WSZ weisen jeweils eine in einer X-Richtung und in einer Y-Richtung angeordnete Empfangsfläche auf.

Der Strang STRA weist eine Vorderseite und eine Rückseite aufweist, wobei in der abgebildeten Draufsicht die Vorderseite dargestellt ist.

Vorliegend sind die Empfangsflächen der Weltraumsolarzellen WSZ auf der Vorderseite des Strangs STRA ausgebildet.

Der Strang STRA weist ein erstes Ende und ein dem ersten Ende gegenüberliegendes zweites Ende auf, wobei die beiden Enden sich jeweils in der y-Richtung entlang einer Seite der an den Enden des Strangs angeordneten Weltraumsolarzelle WSZ erstrecken.

Vorliegend weist jeder der Weltraumsolarzellen WSZ eine mit der jeweiligen Weltraumsolarzelle WSZ verschaltete Bypassdiode SD auf. Hierbei sind die Bypassdioden SD jeweils in einer Ecke der zugeordneten Weltraumsolarzelle WSZ angeordnet und mit zwei Verbindern VB1, VB2 mit der in der X-Richtung und mit der in der Y-Richtung unmittelbar benachbarten Weltraumsolarzelle WSZ verschaltet.

Es versteht sich, dass die Bypassdiode SD und die in der X-Richtung zugeordnete d.h. unmittelbar mit der Weltraumsolarzelle WSZ verschaltete Bypassdiode SD von einem einzigen Deckglas DGS überdeckt sind.

Die Weltraumsolarzellen WSZ weisen jeweils eine in einer Z-Richtung ausgebildete Dicke zwischen 30 µm und 300 µm oder ein Dicke zwischen 50 µm und 160 µm auf.

Die auf der Vorderseite des Strangs STRA angeordneten Schutzanordnungen SA sind jeweils entlang der y-Richtung ausgebildet.

Die Schutzanordnungen SA sind mittels mehreren metallischen Verbindern mit der an den beiden Enden angeordneten Weltraumsolarzellen WSZ des Strangs STRA elektrisch verschaltet.

Die Schutzanordnung SA umfasst eine erste Strangschutzdiode DGDS und ein Metallstreifen BUB und eine zweite Strangschutzdiode DGDS. Des Weiteren ist es bevorzugt, an dem Metallstreifen Kontaktfahnen mit Kontaktflächen K1 auszubilden, wobei die Kontaktfahnen und die Metallstreifen im Allgemeinen einstückig ausgebildet sind.

Der Metallstreifen BUB weist ein erstes kopfseitiges Ende und ein Zwischenstück und ein zweites kopfseitiges Ende auf.

In der Ausführungsform, dargestellt in der Figur 1a, auch als erste Alternative bezeichnet, ist die erste Strangschutzdiode DGDS in der y-Richtung mittels eines der metallischen Verbinder VB1 mit dem ersten kopfseitigen Ende des Metallstreifens BUB in Serie verschaltet.

Ferner ist die zweite Strangschutzdiode DGDS ebenfalls in der y-Richtung mittels eines der metallischen Verbinder VB1 mit dem zweiten kopfseitigen Ende des Metallstreifens BUB in Serie verschaltet.

Die Verbinder VB1 weisen jeweils zwei voneinander durch ein Verbindungsstück beabstandete Kontaktflächen - nicht dargestellt, auf.

Bei der Schutzanordnung SA verbunden mit dem Ende an dem das positive Potential + anliegt, sind die beiden Strangschutzdioden DSGS jeweils mittels eines der in der X-Richtung ausgebildeten Verbinder VB1 mit der Weltraumsolarzelle WSZ verschaltet. Anders ausgedrückt, die beiden Zweige der Strangschutzdioden DGDS sind zueinander parallel und bilden so eine Redundanz aus.

Der Metallstreifen BUB weist zwei Kontaktfahnen K1 für den Anschluss je eines nicht dargestellten flexiblen Kabels auf. Anders ausgedrückt, jeder der Anschlüsse ist vorzugsweise mit genau einem flexiblen Kabel verbunden.

Es sei angemerkt, dass bei jedem der beiden Zweige das nicht dargestellte flexible Kabel über die Kontaktfahnen K1 mit dem Metallstreifen BUB und der Strangschutzdiode DGDS und der Weltraumsolarzelle WSZ in Serie verschaltet ist.

Bei der Schutzanordnung SA, verbunden mit dem Ende an dem das negative Potential anliegt, sind die beiden Strangschutzdioden DSGS jeweils mittels einem der Verbinder VB1 in der negativen X-Richtung mit über eine der jeweilige Kontaktfahnen K1 mit einem nicht dargestellten flexiblen Kabel verschaltet.

Außerdem ist eine der Strangschutzdioden DGDS mittels eines der Verbinder VB1 mit der Bypassdiode der Weltraumsolarzelle WSZ verschaltet. Der Metallstreifen BUB ist vorliegend mittels zwei Verbindern VB1 mit der am Ende des Strangs ausgebildeten Weltraumsolarzelle WSZ verschaltet. Es versteht sich, dass mit einer größeren Anzahl von zueinander parallel geschalteten Verbindern VB1, das Risiko eines Ausfalls sich verringert und der Serienwiderstand sich reduziert.

Ferner ist die erste Strangschutzdiode DGDS und die zweite Strangschutzdiode DGDS ebenfalls in der y-Richtung mittels wenigstens einem metallischen Verbinder VB1 mit dem ersten kopfseitigen Ende des Metallstreifens BUB bzw. mit dem zweiten kopfseitigen Ende des Metallstreifens BUB in Serie verschaltet.

Auch hier sind die beiden Zweige der Strangschutzdioden DGDS zueinander parallel verschaltet abgeordnet und bilden so eine Redundanz aus. Anders ausgedrückt die Ausfallsicherheit wird erhöht.

Es sei angemerkt, dass bei jedem der beiden Zweige die Weltraumsolarzelle WSZ über den Metallstreifen BUB mit der Strangschutzdiode DGDS und den flexiblen Anschlusskabeln in Serie verschaltet sind.

In der Ausführungsform, dargestellt in der Figur 1b, auch als zweite Alternative bezeichnet, werden nur die Unterschiede zu der Ausführungsform, angeführt, in Zusammenhang mit den Zeichnungsunterlagen der Figur 1a, erläutert.

Die erste Strangschutzdiode DGDS ist an dem ersten kopfseitigen Ende, an dem das positive Potential + anliegt, unmittelbar ohne Verbinder VB1 auf dem Metallstreifen BUB angeordnet. Hierdurch lassen gegenüber der Ausführungsform, dargestellt in der Figur 1a, zwei Verbinder VB1 einsparen.

Ferner ist die zweite Strangschutzdiode DGDS an dem zweiten kopfseitigen Ende unmittelbar auf dem Metallstreifen BUB angeordnet.

In den beiden in der Figur 1a bzw. der Figur 1b dargestellten Alternativen sind die beiden Strangschutzdioden DGDS in der X-Richtung jeweils mittels einen der metallischen Verbinder VB1 elektrisch in Serie mit der am Ende des Strangs STRA angeordneten Weltraumsolarzelle WSZ verschaltet.

Es sei angemerkt, dass vorliegend die Strangschutzdioden DGDS jeweils eine eigene Abdeckung in Form eines Deckglases aufweisen. Es versteht sich, dass die Abdeckung jeweils mit der einzelnen Strangschutzdiode DGDS verklebt ist.

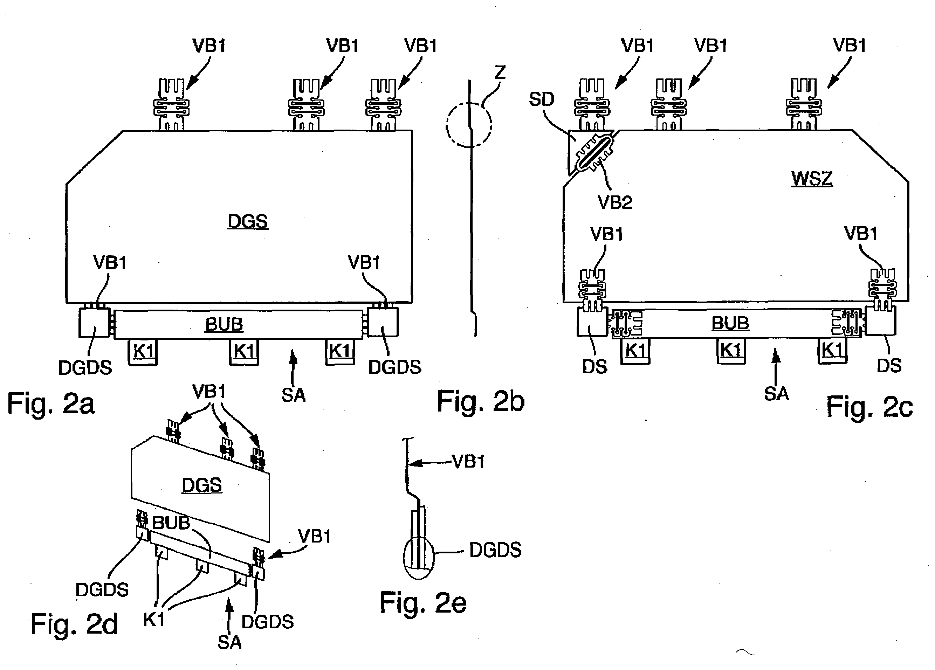

In den Abbildungen der Figuren 2a - 2e sind detaillierte Ansichten unter anderem von der Vorderseite, der Seite und Rückseite der mit einer Weltraumsolarzelle WSZ verschalteten Schutzanordnung SA, dargestellt.

Im Einzelnen zeigt die hierbei die Figur 2b eine Seitensicht, die Figur 2c eine Draufsicht auf die Rückseite und die Figur 2 c eine perspektivische Ansicht auf die Anordnung der Figur 2a.

Die Figur 2e zeigt in einem Ausschnitt eine detaillierte Seitenansicht auf eine Strangschutzdiode DGDS.

Im Folgenden werden nur die Unterschiede zu den vorangegangen Ausführungsformen erläutert.

Die Figur 2a zeigt die Draufsicht auf die mit einem Deckglas DGS bedeckte Vorderseite einer der Weltraumsolarzellen WSZ. An einem der beiden Enden, die eine in Y-Richtung ausgebildete Kante der Weltraumsolarzelle WSZ sind für die serielle Verschaltung mit einer benachbarten - nicht dargestellten Weltraumsolarzelle WSZ - die Kontaktfahnen K1 von insgesamt drei der Verbinder VB1 sichtbar.

Die Verbinder VB1 weisen eine erste Kontaktfläche und eine zweite Kontaktfläche auf. Jeweils eine der beiden Kontaktflächen der drei Verbinder VB1 ist mit der Oberseite der Weltraumsolarzelle WSZ verschweißt. Die andere Kontaktfläche ist für eine Verschaltung mit einer weiteren Weltraumsolarzelle WSZ vorgesehen. Vorliegend sind die beiden Kontaktflächen gleich ausgebildet.

Beide Kontaktflächen weisen mehrere Kontaktfahnen K1 auf. Die jeweiligen Verbindungsstücke zwischen jeweiligen beiden Kontaktflächen der Verbinder VB1 sind mäanderförmig ausgebildet, um die jeweiligen beiden Kontaktflächen mechanisch voneinander zu entkoppeln.

An der gegenüberliegenden langen Kante der Weltraumsolarzelle WSZ ist die Schutzanordnung SA mit den beiden, mit einem als Abdeckschicht ausgebildeten Deckglas geschützten, Strangschutzdioden DGDS und dem Metallstreifen BUB ausgebildet. Es versteht sich, dass das Deckglas im Infraroten transparent ist.

An dem Metallstreifen BUB sind insgesamt drei Kontaktfahnen K1 für den Anschluss der flexiblen Kabel vorgesehen.

In der Seitenansicht der Figur 2b zeigt sich die geringe Dicke des Strangs STRA die unterhalb einem Millimeter liegt. Des Weiteren ist eine Stufe in zwischen dem Metallstreifen BUB und den Kontaktfahnen K1 ausgebildet.

Aus der Rückseitenansicht der Figur 2c ergibt sich, dass die Bypassdiode SD mit einem breiten Verbinder VB2 mit der Unterseite der Weltraumsolarzelle WSZ verschaltet ist. Des Weiteren ist an der gegenüberliegenden Kante die Schutzanordnung SA mittels den Kontaktflächen der Verbinder VB1 verschaltet. Es sei angemerkt, dass der breitere Verbinder VB2 eine andere geometrische Form insbesondere eine größere Breite als der Verbinder VB1 aufweist.

Aus der Darstellung der Figur 2e ergibt sich, dass eine der beiden Kontaktflächen des Verbinders VB1 mit der Oberseite der Strangschutzdiode DGDS verschaltet ist und von dem Deckglas abgedeckt wird. Des Weiteren weist der Verbinder VB1 eine Stufe zwischen den beiden Kontaktflächen auf.

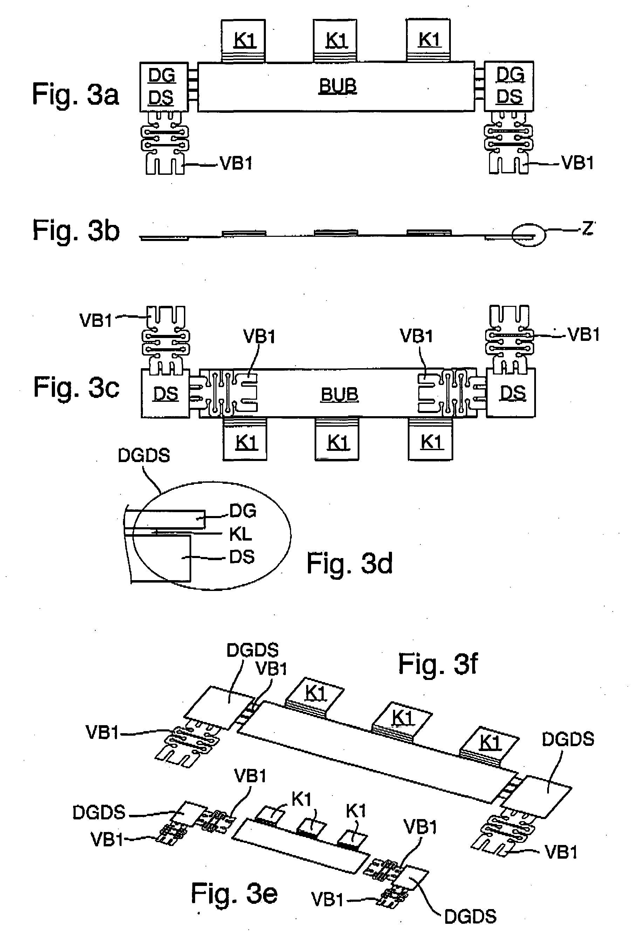

In den Abbildungen der Figuren 3a - 3f sind detaillierte Ansichten auf die Schutzanordnung SA und auf die Verbinder VB1 und der Aufbau der Strangschutzdioden DGDS dargestellt. Im Folgenden werden nur die Unterschiede zu den vorangegangenen Abbildungen erläutert.

Es zeigt sich, dass die Kontaktflächen der Verbinder VB1 jeweils genau drei Kontaktfahnen aufweisen. Auch zeigt sich in der Seitenansicht der Figur 3b dass die Schutzanordnung in der Z-Richtung sehr dünn ausgebildet ist und vorzugsweise eine Dicke kleiner als 1 mm aufweist.

In der Ausschnittsvergrößerung der Figur 3d zeigt sich, dass auf der einen Seite der Strangschutzdiode DGDS ein Deckglas DG mittels eines Klebers KL auf einer Seite der Schutzdiode DS angeordnet.

## Patentansprüche

1. Schutz von Weltraumsolarzellen (WSZ) bei einer Anordnung in Form eines Strangs STRA, wobei
- wenigstens ein Teil der Weltraumsolarzellen (WSZ) nacheinander in Form des sich in einer X-Richtung erstreckenden Strangs (STRA) angeordnet sind,
- der Strang (STRA) wenigstens zwei Weltraumsolarzellen (WSZ) umfasst,
- jeweils zwei in der X-Richtung unmittelbar benachbarte Weltraumsolarzellen (WSZ) mittels einem oder mehreren metallischen Verbindern (VB1) elektrisch seriell miteinander verschaltet sind,
- die Weltraumsolarzellen (WSZ) jeweils eine in einer X-Richtung und in einer Y-Richtung angeordnete Empfangsfläche aufweisen,
- der Strang (STRA) eine Vorderseite und eine Rückseite aufweist, wobei die Empfangsflächen der Weltraumsolarzellen (WSZ) auf der Vorderseite des Strangs (STRA) ausgebildet sind,
- der Strang (STRA) ein erstes Ende und ein dem ersten Ende gegenüberliegendes zweites Ende aufweist, wobei die beiden Enden sich jeweils in der y-Richtung entlang einer Seite der an den Enden des Strangs angeordneten Weltraumsolarzelle (WSZ) erstrecken,
- jede Weltraumsolarzelle (WSZ) eine mit der jeweiligen Weltraumsolarzelle (WSZ) verschaltete Bypassdiode (SD) aufweist,
- die Weltraumsolarzellen (WSZ) jeweils eine in einer Z-Richtung ausgebildete Dicke zwischen 30 µm und 300 µm oder ein Dicke zwischen 50 µm und 160 µm aufweisen,
**dadurch gekennzeichnet, dass**
- auf der Vorderseite eine Schutzanordnung (SA) an wenigstens einem der beiden Enden entlang der y-Richtung ausgebildet ist und die Schutzanordnung mit der an dem Ende angeordneten Weltraumsolarzelle (WSZ) des Strangs (STRA) mittels eines der metallischen Verbinder (VB1) elektrisch verschaltet ist, wobei die Schutzanordnung (SA) eine erste Strangschutzdiode (DGDS) und ein Metallstreifen und eine zweite Strangschutzdiode (DGDS) umfasst,
- der Metallstreifen (BUB) ein erstes kopfseitiges Ende und ein Zwischenstück und ein zweites kopfseitiges Ende aufweist,
- in einer ersten Alternative die erste Strangschutzdiode (DGDS) in der y-Richtung mittels eines der metallischen Verbinder mit dem ersten kopfseitigen Ende des Metallstreifens (BUB) in Serie verschaltet ist und die zweite Strangschutzdiode (DGDS) in der y-Richtung mittels eines der metallischen Verbinder (VB1) mit dem zweiten kopfseitigen Ende des Metallstreifens (BUB) in Serie verschaltet ist, wobei die Verbinder jeweils zwei voneinander durch ein Verbindungsstück beabstandete Kontaktflächen aufweisen, oder
- in einer zweiten Alternative die erste Strangschutzdiode (DGDS) unmittelbar an dem ersten kopfseitigen Ende auf dem Metallstreifen (BUB) und die zweite Strangschutzdiode (DGDS) unmittelbar an dem zweiten kopfseitigen Ende auf dem Metallstreifen (BUB) angeordnet ist,
- in beiden Alternativen die beiden Strangschutzdiode (DGDS) in der X-Richtung jeweils mittels einen der metallischen Verbinder (VB1) elektrisch in Serie mit der am Ende des Strangs (STRA) angeordneten Weltraumsolarzelle (WSZ) verschaltet sind, oder
- jede Strangschutzdiode (DGDS) ungehäust ist und genau einen p/n Übergang und einen Metallkontakt an einer Oberseite und einen Metallkontakt an einer Unterseite aufweist, wobei die Metallkontakte jeweils wenigstens 50% der Gesamtfläche der Oberseite und der Unterseite überdecken,
- jede Strangschutzdiode (DGDS) auf der Oberseite eine eigene Abdeckung aufweist, wobei die Abdeckung mit der Oberseite verklebt ist,
- die Schutzanordnung (SA) insgesamt flach ausgebildet ist und in einer Z-Richtung eine Dicke kleiner als 1 mm aufweist,
- die Ausdehnung der gesamten Schutzanordnung (SA) in der Y-Richtung wenigstens einen Faktor fünf größer ist als die Ausdehnung in der X-Richtung.

2. Anordnung von Weltraumsolarzellen (WSZ) nach Anspruch 1, **dadurch gekennzeichnet, dass** die Verbinder eine erste Kontaktfläche und eine zweite Kontaktfläche aufweisen, wobei eine der beiden Kontaktflächen mit dem Metallkontakt an der Unterseite oder mit dem Metallkontakt an der Oberseite der Strangschutzdiode verschaltet ist und die andere der beiden Kontaktflächen mit dem Metallstreifen verschaltet ist.

3. Anordnung von Weltraumsolarzellen (WSZ) nach Anspruch 1 oder Anspruch 2, **dadurch gekennzeichnet, dass** bei den Verbindern die beiden Kontaktflächen gleich oder unterschiedlich ausgebildet sind.

4. Anordnung von Weltraumsolarzellen (WSZ) nach einem der vorangegangenen Ansprüche, **dadurch gekennzeichnet, dass** bei den Verbindern (VB1) wenigstens eine der beiden Kontaktflächen oder beide Kontaktflächen jeweils eine Kontaktfahne oder mehrere Kontaktfahnen aufweisen.

5. Anordnung von Weltraumsolarzellen (WSZ) nach einem der vorangegangenen Ansprüche, **dadurch gekennzeichnet, dass** bei den Verbindern (VB1) das Verbindungsstück zwischen den beiden Kontaktflächen mäanderförmig ausgebildet ist, um die beiden Kontaktflächen mechanisch voneinander zu entkoppeln.

6. Anordnung von Weltraumsolarzellen (WSZ) nach einem der vorangegangenen Ansprüche, **dadurch gekennzeichnet, dass** die beiden Kontaktflächen der Verbinder (VB1) jeweils flach ausgebildet sind und jeweils eine in der Z-Richtung ausgebildete Dicke zwischen 0,01 mm und 0,7 mm aufweisen.

7. Anordnung von Weltraumsolarzellen (WSZ) nach einem der vorangegangenen Ansprüche, **dadurch gekennzeichnet, dass** die Verbinder (VB1) eine rechteckförmige Fläche aufweisen und die lange Seite der rechteckförmigen Fläche eine mindestens Faktor 5 größere Ausdehnung als die kurze Seite aufweist.

8. Anordnung von Weltraumsolarzellen (WSZ) nach einem der vorangegangenen Ansprüche, **dadurch gekennzeichnet, dass** die Bypassdiode (SD) unmittelbar mit der jeweiligen Weltraumsolarzelle (WSZ) mittels eines breiten Verbinders (VB2) verschaltet.

9. Anordnung von Weltraumsolarzellen (WSZ) nach einem der vorangegangenen Ansprüche, **dadurch gekennzeichnet, dass** eine der beiden Strangschutzdioden (DGDS) mit der Bypassdiode (SD) unmittelbar verschaltet ist.

10. Anordnung von Weltraumsolarzellen (WSZ) nach einem der vorangegangenen Ansprüche, **dadurch gekennzeichnet, dass** an beiden Enden des Strangs eine Schutzanordnung (SA) ausgebildet ist.

11. Anordnung von Weltraumsolarzellen (WSZ) nach einem der vorangegangenen Ansprüche, **dadurch gekennzeichnet, dass** bei einem Lichteinfall auf die Vorderseite der Weltraumsolarzellen (WSZ) der Strom ausschließlich durch die Strangschutzdioden (DGDS) und den Metallstreifen (BUB) zu der Anschlussleitung fließt.

12. Anordnung von Weltraumsolarzellen (WSZ) nach einem der vorangegangenen Ansprüche, **dadurch gekennzeichnet, dass** die Kontaktfahnen eine Dicke zwischen 0,01 mm und 0,5 mm oder zwischen 0,02 mm und 0,2 mm aufweisen.

13. Anordnung von Weltraumsolarzellen (WSZ) nach einem der vorangegangenen Ansprüche, **dadurch gekennzeichnet, dass** die Abdeckung der Strangschutzdiode (DGDS) im Infraroten transparent ist, um die Sonneneinstrahlung zu reflektieren und oder die Abdeckung als Deckglas ausgebildet ist und die Oberseite der Strangschutzdiode (DGDS) eine durchgängige oder zu mehr als 80% der Oberfläche ausgebildete metallische Schicht aufweist, um die Sonnenstrahlung zu reflektieren.

14. Anordnung von Weltraumsolarzellen (WSZ) nach einem der vorangegangenen Ansprüche, **dadurch gekennzeichnet, dass** die Schutzanordnung (SA) unmittelbar an einem der beiden Enden ausgebildet ist und der Abstand in der X-Richtung zwischen der Schutzanordnung (SA) und der mit der Schutzanordnung (SA) verschalteten Weltraumsolarzelle in einem Bereich zwischen 10 µm und 10 mm oder in einem Bereich zwischen 100 µm und 2 mm liegt.

15. Anordnung von Weltraumsolarzellen (WSZ) nach einem der vorangegangenen Ansprüche, **dadurch gekennzeichnet, dass** mittels den Metallstreifen (BUB) und / oder der Anschlussleitung eine Kühlung für die Strangschutzdioden (DGDS) ausgebildet ist.
